# EUROPEAN PATENT APPLICATION

(11) **EP 4 451 812 A1**
(43) Date of publication of application: **23.10.2024**
(21) Application number: 23169228.6
(22) Date of filing: 21.04.2023
(51) Int. Cl.: H05K 3/34, H05K 1/02

(54) **PRINTED CIRCUIT BOARD AND METHOD OF PRODUCING THEREOF**

(71) Applicant: Harman Becker Automotive Systems GmbH, 76307 Karlsbad (DE)
(72) Inventor: BILIGA-NISIPEANU, Paul-Alexandru, 031942 Bucharest (RO); BARBALATA, Vlad-Alexandru, 042183 Bucharest (RO); CRACIUN, Liviu-Dumitru, 76761 Ruelzheim (DE); JIANU, Ionut-Liviu, 237500 Urzica (RO); KRAFT, Günther, 76185 Karlsruhe (DE)
(74) Representative: Rummler, Felix

(57) **Abstract**

A Printed Circuit Board, PCB, comprising: a first thermal pad (308) on a first side of the PCB for a first integrated circuit (102), IC, having a first exposed pad; a second thermal pad (304) on a second side of the PCB for a second integrated circuit (106), IC, having a second exposed pad, wherein the first thermal pad (308) and the second thermal pad (304) overlap at least partially to each other in a direction perpendicular to the plane of the PCB.

## Description

### TECHNICAL FIELD

The present disclosure relates to a printed circuit board (PCB), a layout structure of the PCB, use of the PCB and a method of producing the PCB.

### BACKGROUND OF THE INVENTION

Printed circuit boards (PCBs) have become an essential part of people's daily lives. PCBs are widely used in electronic devices, such as smartphones, computers, cars and home appliances. In particular, with the increasing demand for smaller, compacter and lighter electronic devices, the size of the PCBs plays a critical role in achieving this goal. One solution for providing compact PCBs is to use a multiplayer PCB, such as double sided PCB. Specifically, instead of having one layer of copper traces and components on a single side, a multilayer PCB has several layers sandwiched together with connections between them. This allows a higher density of components and connections in a smaller area than a single-layer PCB. Such multiplayer PCB is for example described in US7, 707, 715 B2.

Additionally, with increasing competition, changing customer demands, and rising production costs, manufacturers are currently facing immense pressure to reduce the production cost of PCBs and related products. As a result, various strategies to lower the costs of production have been explored, so as to remain competitive in the market and maintain profitability.

### SUMMARY

One of a number of aspects of the present disclosure relates to a Printed Circuit Board, PCB, comprising: a first thermal pad on a first side of the PCB for a first integrated circuit, IC, having a first exposed pad; and a second thermal pad on a second side of the PCB for a second integrated circuit, IC, having a second exposed pad, wherein the first thermal pad and the second thermal pad overlap at least partially in a direction perpendicular to the plane of the PCB. By arranging two partially overlapping thermal pads on both sides of the PCB, the side of the PCB opposite to an IC with an exposed pad is left open and can be utilized to accommodate another thermal pad, thus, the PCB can be made more compact.

In one or more embodiment, the first thermal pad and the second thermal pad may substantially identical or have different dimensions. In other words, the two thermal pads do not have to be identical. This ensures that the PCB is adaptable to ICs having exposed pads of different dimensions. As such, the PCB can be adapted to at least two types of ICs.

In one or more embodiment, geometric centers of the first thermal pad and the second thermal pad may be aligned and may overlap in the direction perpendicular to the plane of the PCB, so that heat dissipated by the thermal pads would not affect the function of components on the opposite side of the PCB. Furthermore, such an arrangement would effectively utilize the available space on the PCB.

In one or more embodiment, the PCB may further comprise a plurality of thermal vias, with one end of each thermal via connecting to the first thermal pad and the other end connecting to the second thermal pad. Alternatively, the thermal vias may be through-holes traversing the thermal pads and the PCB.

In one or more embodiment, the PCB may further comprise a first IC, the first exposed pad of the first IC may connect to the first thermal pad of the PCB, and the second thermal pad may remain unoccupied. Alternatively, the PCB further comprises a second IC, the second exposed pad of the second IC may connect to the second thermal pad of the PCB, and the first thermal pad may remain unoccupied. It is preferable that in implementations, only one of the thermal pads is connected (soldered) to an IC, and the other thermal pad is intentionally left unoccupied. In such way, heat generated by the IC that is implemented (populated) can be effectively dissipated. Still alternatively, it may be also possible that both the first and the second thermal pads remain unoccupied. As such, a single PCB can be adapted for at least three implementations. This can significantly reduce the production and certification cost of the PCB. It is also conceivable that both the first and the second thermal pads may be populated with ICs, if the ICs dissipate minimal heat during working.

In one or more embodiment, the first IC and the second IC may be video serializer and video deserializer, respectively. By implementing ICs relying on similar or same supporting components to enable them working properly, the PCB as described above can be most efficiently designed and used. Other ICs, such as radio frequency modulators and demodulators, digital-to-analog converters, analog-to-digital converters, or wireless transmitters and receivers, may be selected based on specific needs. In other words, the ICs that can be populated and use the thermal pads are not limited to any type.

In one or more embodiment, the PCB may comprise more thermal pads, e.g. a third and a fourth thermal pads. The third and fourth thermal pads may include the same or similar features to the first and the second thermal pads, respectively.

One of a number of aspects of the present disclosure relates to a layout structure of a PCB, comprising: a first footprint on a first side of the layout structure for a first IC to be connected to the PCB; and a second footprint on a second side of the layout structure for a second IC to be connected to the PCB; wherein the first footprint and the second footprint overlap at least partially in a direction perpendicular to the plane of the PCB.

In one or more embodiment, the first footprint and the second footprint may be substantially identical or have different dimensions. Still preferably, geometric centers of the first footprint and the second footprint may be aligned and may overlap in a direction perpendicular to the plane of the PCB.

One of a number of aspects of the present disclosure relates to a method of manufacturing a PCB, comprising: providing a substrate; forming a first thermal pad on the first side of the substrate; and forming a second thermal pad on the second side of the substrate, wherein the first thermal pad and the second thermal pad overlap at least partially in a direction perpendicular to the plane of the PCB. The substrate may be a copper clad laminate including a laminate sandwiched by two copper layers.

In one or more embodiment, the method may further comprise forming thermal vias in the PCB, with one end of each thermal via connecting to the first thermal pad and the other end connecting to the second thermal pad. Alternatively, the thermal vias may be through-holes traversing the thermal pads and the PCB.

In one or more embodiment, the method may comprise connecting a first exposed pad of a first IC to the first thermal pad and remaining the second thermal pad unoccupied. Alternatively, the method may comprise connecting a second exposed pad of a second IC to the second thermal pad and remaining the first thermal pad unoccupied.

In one or more embodiment, the method may comprise forming more thermal pads, e.g. a third and a fourth thermal pads on the PCB. The third and fourth thermal pads may be formed by the same or a similar method of forming the first and the second thermal pads, respectively.

One of a number of aspects of the present disclosure relates to using of the PCB as described above, for example, in consumer electronics, automobile, or the like.

### BRIEF DESCRIPTION OF THE DRAWINGS

Example embodiments of the disclosure will be described, by way of example only, with reference to the accompanying drawings in which:
Fig. 1 is a perspective view showing two integrated circuits having exposed pads;
Fig. 2A and 2B are an exemplary layout structure of PCBs according to prior art;
Fig. 3A and 3B is an exemplary layout structure of top side and bottom side of a PCB according to an embodiment;
Fig.4A is a cross sectional view of a portion of the PCB with thermal pads according to an embodiment; Fig.4B is a cross sectional view of a portion of the PCB with thermal pads according to another embodiment;
Fig. 5 is a three-dimensional view of a portion of the PCB with thermal pads according to an embodiment; and
Fig. 6A and 6B are sectional views sequentially illustrating the process of fabricating the PCB according to an embodiment.

### DETAILLED DESCRIPTION

There now follows, by way of example only, a detailed description of exemplary embodiments of the present disclosure. These examples are described in reference to the figures identified above, which are included to provide further detail and clarity. It should be understood that the examples described are not limiting, and that other examples falling within the scope of the disclosure may exist.

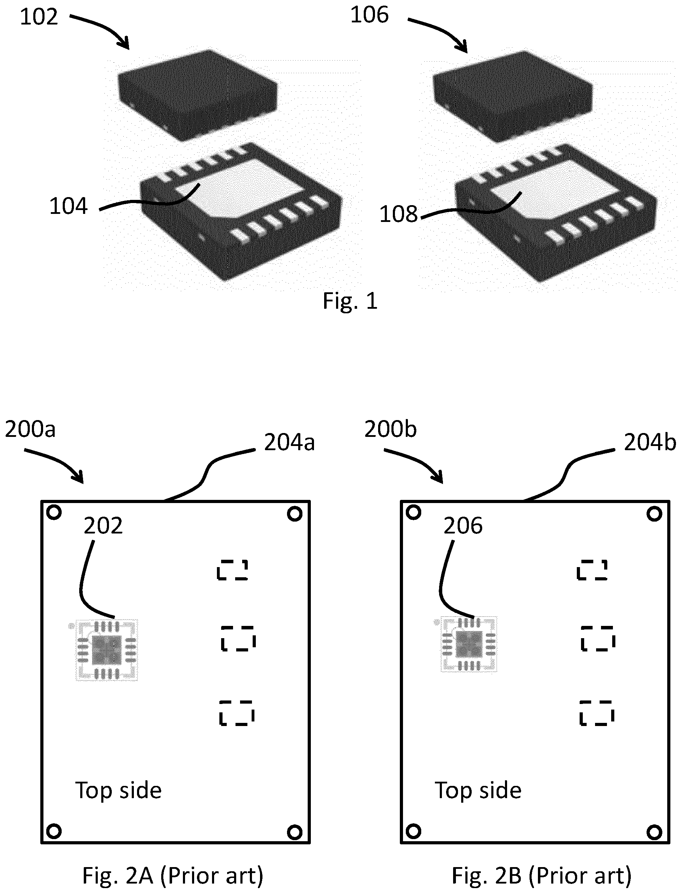

Referring to Fig. 1, there is shown a first integrated circuit (also known as chip or microchip) 102 and a second integrated circuit (IC) 106. The first and the second ICs 102 and 106 are usually mounted on a PCB to create functional electronic devices. Both ICs 102 and 106 are provided with exposed pads 104 and 108, respectively. The exposed pads 104 and 108 are exposed metal plates on the IC package that is left exposed on the underside the IC 102 and 106, respectively. The exposed pads may also serve as heat sink. The exposed pads 104 and 108 are used to improve the thermal performance and electrical grounding of the ICs. They are preferably connected to a ground plane or power plane on the PCB. By providing a larger area for heat dissipation, the exposed pad helps to prevent overheating and improves the reliability and lifespan of the ICs.

In one embodiment, the ICs 102 and 106 may be components both including exposed pads for thermal dissipation. The ICs 102 and 106 may be ICs used in similar applications. For example, the first and the second ICs 102 and 106 may be video serializer and video deserializer, radio frequency modulator and demodulator, digital-to-analog converter and analog-to-digital converter, wireless transmitter and receiver, or the like. In addition to this, or as another option, it is possible that the first and the second ICs 102 and 106 rely on similar or identical supporting components to enable them function properly, and/or are used in a comparable PCB layout. Alternatively, any ICs can be used based on actual needs.

Referring to Fig. 2A, there is provided a layout structure 200a of a PCB 204a used in the prior art. When the PCB 204a is designed, a layout structure 200a is created to plan for incorporating all necessary components, electrical connections, and other features required for an intended application. One important aspect of the layout structure 200a is the creation of footprint for each component. A footprint is a pattern or layout on the PCB 204a that defines the location and physical dimension of a component and its electrical connections. The footprint ensures that the component has its own place to be soldered to the PCB, and it is designed to match the specific dimensions and pin locations of the component being used.

To implement (also known as populate) the first IC 102 shown in Fig. 1, a footprint 202 is created for the first IC 102 on the layout structure 200a at the top side of a PCB 204a. The footprint 202 illustrates locations and dimensions of solder pads and a thermal pad which will be created on the PCB 204a. Solder pads are the areas on the PCB where the IC's leads or contacts are attached by using solder. The thermal pad is a copper pad on the PCB where the IC's exposed pad is attached by using solder to dissipate heat generated by the IC. The copper pad is generally connected to a ground plane through vias to improve heat dissipation. The layout structure 200a may also include footprints for other electronic components or ICs that are illustrated as dashed rectangles.

Similarly, referring to Fig. 2B, to implement the second IC 106 shown in Fig. 1, a further layout structure 200b of a PCB 204b is designed. On the layout structure 200b, a footprint 206 is created for the second IC 106 at the top side of the PCB 204b. The footprint 206 on the layout structure 200b illustrates solder pads and a thermal pad which corresponds to the leads and the exposed pad 108 of the second IC 106.

In the case of the prior art shown in Fig. 2A and 2B, two separate layout structures for two PCBs have to be created for the first IC 102 and the second IC 106, respectively. Specifically, since both the first IC 102 and the second IC 106 have exposed pads to meet heat dissipation needs, the opposite side (bottom side) of the PCBs underneath the ICs cannot be used to accommodate any additional components and must be kept free (unoccupied).Consequently, during manufacturing, two PCBs 204a and 204b have to be manufactured to implement the two ICs. Such process involves high production and certification costs.

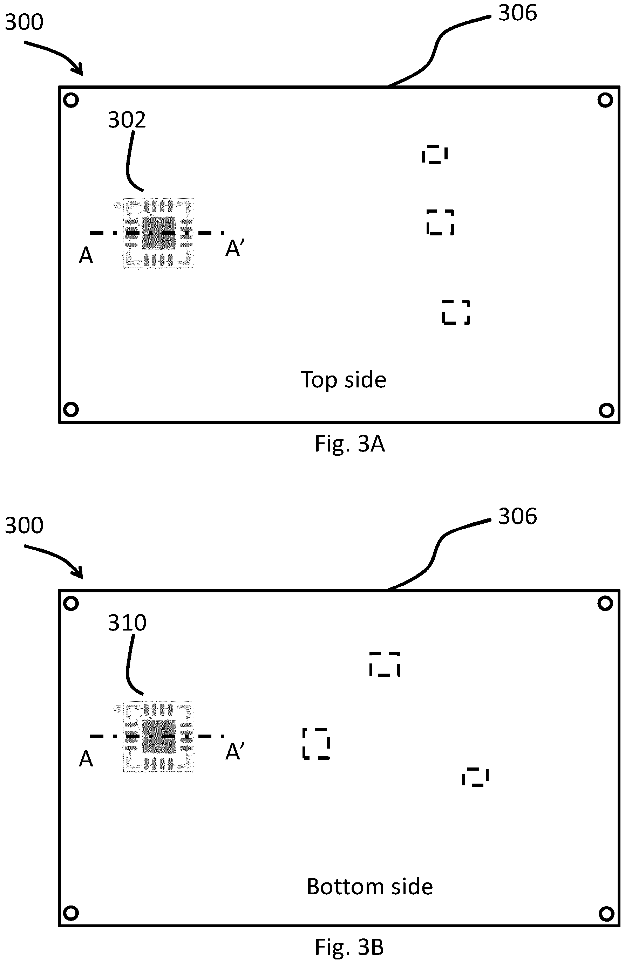

Referring to Fig. 3A and 3B, there is provided an exemplary layout structure 300 of a PCB 306 according to an embodiment of the present disclosure. Fig. 3A shows a first side (top side) of the layout structure 300 of the PCB 306, and Fig. 3B shows a second side (bottom side) of the layout structure 300 of the PCB 306.

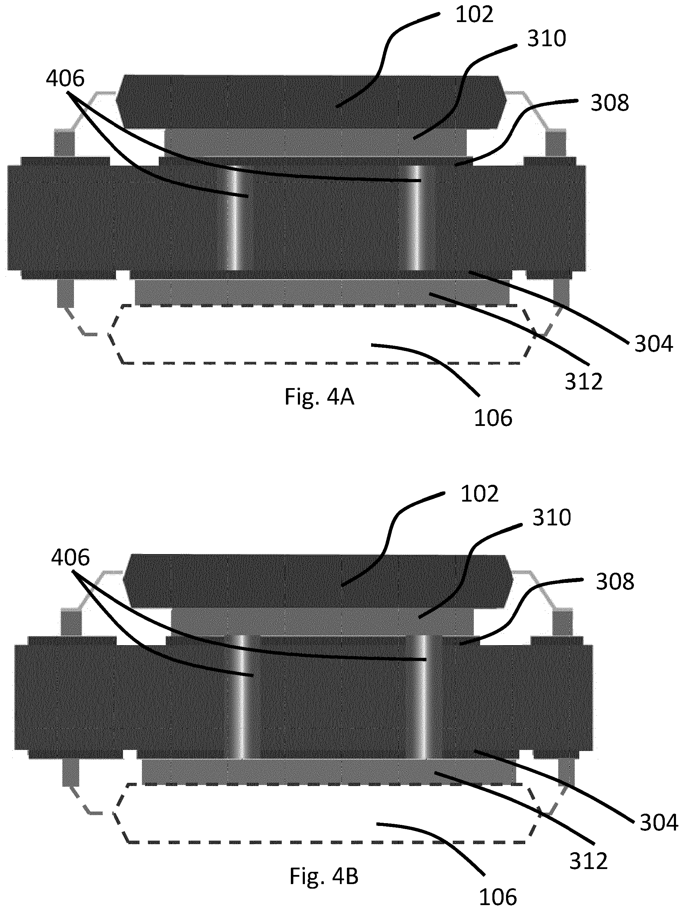

As can be seen in Fig. 3A, a first footprint 302 is created for the first IC 102. The first footprint 302 illustrates locations and dimensions of solder pads and a first thermal pad 308 (can be seen from Fig. 4) which will be created on the PCB 306 for the first IC 102. Solder pads are the areas on the PCB where the first IC 102's leads or contacts are attached by using solder. The first thermal pad 308 may be a copper pad on the PCB where the IC's exposed pad 104 is attached by using solder to dissipate heat generated by the IC 102. The thermal pad 308 may be connected to a ground plane through vias to improve heat dissipation.

As shown in Fig. 3B, on the second side (bottom side) of the layout structure 300 of the PCB 306, a second footprint 310 is created for the second IC 104. Similarly, the second footprint 310 illustrates locations and dimensions of solder pads and a second thermal pad 304 (Fig. 4) which will be created on the PCB 306 for the second IC 106. The second thermal pad 304 may be a copper pad on the PCB 306 where the second IC 106's exposed pad 108 is attached by using solder to dissipate heat generated by the second IC 106. The first thermal pad 308 and the second thermal pad 304 can be observed from Fig. 4, which is a cross sectional view of the PCB 306 along line AA'.

The layout structure 300 may also include footprints for other electronic components or ICs that are illustrated as dashed rectangles. It goes without saying that the layout structure 300 is for illustration purpose only. The number and variety of electronic components or ICs can be selected as needed, and they can be positioned anywhere on the PCB to fulfil actual application needs.

Fig. 4A is a cross sectional view of the portion of the PCB 306 with thermal pads according to the embodiment. The first thermal pad 308 is provided on the first side (top side) of the PCB 306, and the second thermal pad 304 is provided on the second side (bottom side) of the PCB 306. The first thermal pad 308 at least partially overlaps with the second thermal pad 304 in a direction perpendicular to the plane of PCB 306. Preferably, a plurality of thermal vias 406 may be provided in the PCB 306 to facilitate heat dissipation. The first thermal pad 308 and the second thermal pad 304 are connected by the plurality of thermal vias 406, with one end of each thermal via connecting to the first thermal pad 308 and the other end connecting to the second thermal pad 304. This ensures that the openings of the thermal vias 406 at the surface of the PCB are in direct contact with the corresponding thermal pads, establishing a reliable thermal connection.

Alternatively, according to one or more embodiments as shown in Fig. 4B, the thermal vias 406 can be designed as through-holes traversing the thermal pads and the PCB, with the openings of the vias ends at the outer surfaces of the thermal pads. Such design can simplify the production of the PCB and reduce the production costs subsequently. In another alternative embodiment, the thermal vias may be designed as such that only a portion of them penetrate the PCB and/or the thermal pads, while the remaining portion may connect to one or more thermal planes within the PCB. In other words, the design of the thermal vias can be modified as needed based on actual needs.

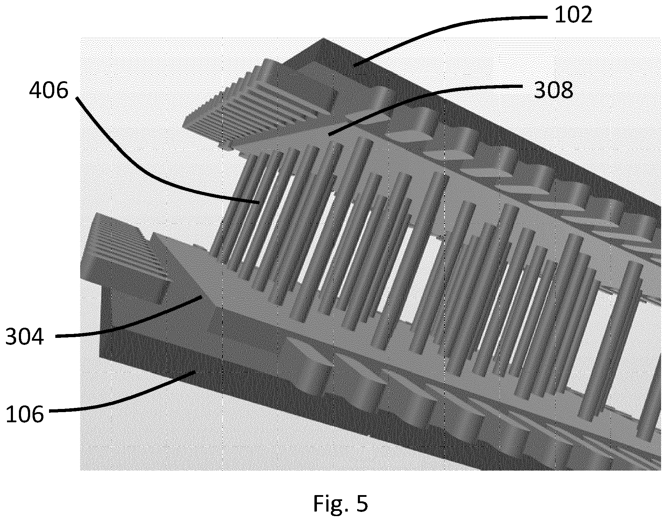

A three-dimensional view of the structure of the thermal pads and thermal vias on the PCB, particularly in the area where the thermal pads overlap, can be observed from Fig. 5. In some embodiment, the first thermal pad and the second thermal pad fully overlap with each other (have a same dimension). In other words, the dimensions of the two thermal pads do not have to be identical. For example, the first thermal pad 308 may have a dimension of 5mm*5mm, the second thermal pad 304 may have a dimension of 7mm*7mm. In such case, heat dissipation of the IC soldered on the smaller thermal pad may be further facilitated by the larger unoccupied thermal pad positioning on the opposite side of the IC.

In the present disclosure, it is preferable that the centroids (geometric center) of the two thermal pads are aligned and overlap in the direction perpendicular to the plane of the PCB, so that heat dissipated by the thermal pads would not affect the function of components on the opposite side of the PCB. Also, such arrangement may provide an efficient way of utilizing the areas on the PCB.

In an implementation in which the first IC 102 is required, it is soldered on the top side of the PCB 306 at a specific location that corresponds to the first footprint 302. The exposed pad 104 of the first IC 102 is applied (soldered) on the first thermal pad 308 through a first solder 310. In this case, the second thermal pad 304 remains unoccupied (free from being connected to any component). As such, the thermal pad 308 along with the thermal vias 406 dissipates heat generated by the first IC 102. In addition, the heat dissipation effect is further improved by the existence of the second thermal pad 304.

Similarly, in an implementation in which the second IC 106 is required, it is soldered on the bottom side of the PCB 306 at a specific location that corresponds to the second footprint 310. The exposed pad 108 of the second IC 106 is applied (soldered) on the second thermal pad 304 through a second solder 312. In this case, the first thermal pad remains unoccupied (free from being attached to any component). As such, the thermal pad 304 along with the thermal vias 406 dissipates heat generated by the second IC 106. In addition, the heat dissipation effect is further improved by the existence of the first thermal pad 308. It goes without saying that in the implementations, contact leads of the first IC 102 and the second IC 106 are also soldered on corresponding solder pads of the PCB.

In the present disclosure, while it is preferable to populate only one of the thermal pads with an IC at a time to optimize heat dissipation, it is conceivable that both thermal pads can be used if the ICs produce minimal heat during operation.

In one or more embodiments, the ICs 102 and 106 may be a video serializer and a video deserializer having exposed pads with same or different dimensions, respectively. For example, if the video serializer is implemented, it is mounted on the side of the PCB that is dedicated for the video serializer, and the other side of the PCB is left free. Similarly, if the video deserializer is implemented, it is mounted on the side of the PCB that is dedicated for the video deserializer, and the other side of the PCB is left free. Other ICs, such as radio frequency modulators and demodulators, digital-to-analog converters, analog-to-digital converters, or wireless transmitters and receivers, may be selected based on specific needs. In other words, the ICs that can be populated are not limited to any type.

In one or more embodiments, it may be possible that none of the ICs 102 and 106 are required. In such case, both the first thermal pad 308 and the second thermal pad 304 may be unoccupied. Based on the present disclosure, it is also conceivable that further thermal pads may be included on the PCB, for example, third and fourth thermal pads, the further thermal pads may be arranged in a similar way as described above.

The PCB layout according to the present disclosure takes advantage of both the top and bottom sides of the board to include thermal pads for ICs in an overlapping arrangement. This design and the produced PCB make efficient use of space that would otherwise go unused due to the thermal characteristics of an IC having an exposed pad. Specifically, traditionally, the side of the PCB opposite to an IC with an exposed pad is intentionally left unused to enable effective heat dissipation during operation. The present disclosure adapts a single PCB for multiple applications involving using different ICs having exposed pads. Consequently, the PCB can be made more compact, and the production and certification cost of PCBs can be significantly reduced.

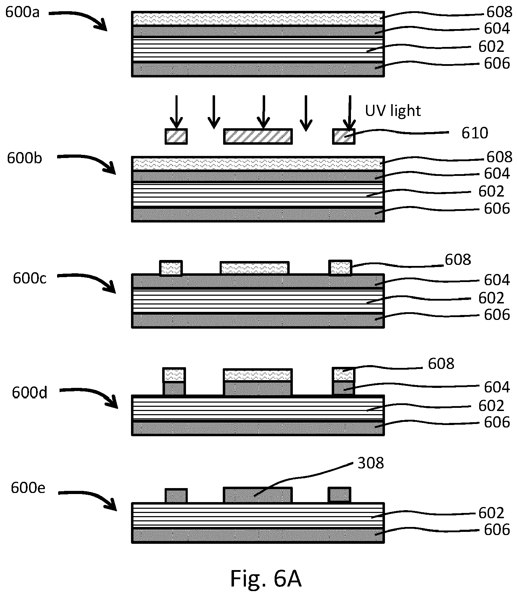

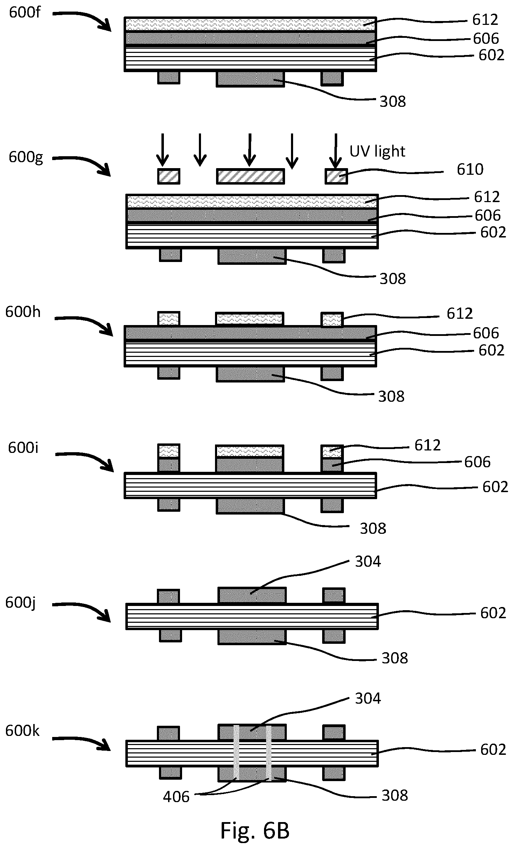

Fig. 6A and 6B are sectional views sequentially illustrating the process of fabricating a PCB according to an exemplary embodiment. At step 600a, a layer of photoresist 608 is applied on a substrate. The photoresist may be a positive photoresist or a negative photoresist. The substrate may be a copper clad laminate including a laminate 602 sandwiched by two copper layers 604 and 606. In addition to the copper clad laminate shown in Fig. 6, another laminate with multiple layers of copper pads may also be used. The choice of the substrate depends on specific requirements of the PCB, such as desired electrical properties, mechanical strength, and environmental conditions.

At step 600b, the substrate is exposed to UV light through a photomask 610, which is a mask that has the pattern of the desired electrodes, e.g. the solder pads and the thermal pad of the first IC 102. The process shown in Fig. 6 uses a positive photoresist. Thus, after exposure, the photoresist dissolves away at the areas that were exposed to light, leaving behind a patterned layer on the substrate, as shown in 600c. Afterwards, the copper layer 604 is etched to form the pattern shown in step 600d. At step 600e, the remained photoresist 608 is dissolved and the first thermal pad 308 is formed. The process is repeated for the other side of the PCB. At step 600f, the photoresist 612 is applied on the copper layer 606. At step 600g, the substrate is exposed to UV light through a photomask 610, which is a mask that has the pattern of the desired electrodes, e.g. the solder pads and the thermal pad of the second IC 106. After exposure, the photoresist dissolves away at the areas that were exposed to light, leaving behind a patterned layer on the substrate, as shown in 600h. Afterwards, the copper layer 606 is etched to form the pattern shown step 600i. At step 600j, the remained photoresist 608 is dissolved and the second thermal pad 304 is formed.

At step 600k, thermal vias is formed in the PCB. The formation of thermal vias may be achieved through various methods, including mechanical drilling, laser drilling, or any other suitable method. Mechanical drilling involves the use of a drill bit to create holes in the PCB. The size and shape of the holes may vary depending on the design and requirements of the PCB. Alternatively, laser drilling may also be used to create the thermal vias. This method uses a high-powered laser to remove material from the PCB and create the required holes. Once the holes are formed, copper plating may be applied to the inner walls of the vias to enhance thermal conductivity. The plating material used may vary, depending on the design specifications of the PCB. The PCB produced in this process is similar to that shown in Fig. 4B, in which the thermal vias transverse the thermal pads and the PCB. Alternatively, according to the present disclosure, the step 600k may also be performed before forming the thermal pads and the contact pads. That is, before the step 600a. In other words, the thermal vias 406 (along with other vias) can be drilled before forming the thermal pads and the contact pads.

It goes without saying that the methods are not limited and other methods may be applied. For example, to produce the PCB shown in Fig. 4A, a laminate material may be firstly drilled to form the thermal vias. Followed a layer of copper may be applied on the laminate by sputtering and electro-chemical deposition. Afterwards, lithography process similar as described above may be used to form the thermal pads and contact pads.

In the present disclosure, it is preferable that the first thermal pad 308 may be formed in a way in which it at least partially overlaps with the second thermal pad 304 in a direction perpendicular to the plane of PCB 306. It may be possible that the first thermal pad 308 and the second thermal pad 304 may be formed in a way that they fully overlap in the direction perpendicular to the plane of the PCB 306. This may be the case when the first thermal pad 308 and the second thermal pad 306 have a same dimension. It goes without saying that the dimensions of the two thermal pads do not have to be identical. It is also preferable that the centroids (geometric center) of the two thermal pads are aligned and overlap in the direction perpendicular to the plane of the PCB, so that heat dissipated by the thermal pads would not affect the function of components on the opposite side of the PCB. In some embodiments, further thermal pads may be formed on the PCB by the process as described above or by similar processes.

It is conceivable that the steps shown in Fig. 6 are only a subset of the overall process required to fabricate a functional PCB. In other words, there are additional steps that may be performed beyond those shown in the figure, depending on specific application requirements. For example, after patterning the electrode on the substrate as shown in Fig. 6, additional processing steps may be performed to apply a solder mask, which is a protective coating applied to the surface of the PCB to protect the copper traces and prevent solder from bridging between adjacent traces. The process may include applying a surface finish to protect the exposed copper and improve the electrical conductivity of the traces. The process may further include testing and inspection to ensure that the final device meets the required specifications and is free from defects. This may involve a range of tests, such as electrical testing, mechanical testing, and visual inspection. Overall, the skilled person in the field is familiar with the additional steps that may be required and can adapt the process as needed to achieve desired outcomes.

As one skilled in the art would appreciate, the embodiments disclosed in the present disclosure can be combined in any combination. In other words, the features, components, and methods described can be combined to suit specific needs and requirements of a particular application.

## Claims

1. A Printed Circuit Board, PCB, comprising:
a first thermal pad on a first side of the PCB for a first integrated circuit, IC, having a first exposed pad; and
a second thermal pad on a second side of the PCB for a second integrated circuit, IC,
having a second exposed pad,
wherein the first thermal pad and the second thermal pad overlap at least partially in a direction perpendicular to the plane of the PCB, preferably, geometric centers of the first thermal pad and the second thermal pad are aligned and overlap in the direction perpendicular to the plane of the PCB.

2. The PCB according to claim 1, further comprising a plurality of thermal vias, with one end of each thermal via connecting to the first thermal pad and the other end connecting to the second thermal pad, or wherein the thermal vias traverse the thermal pads and the PCB.

3. The PCB according to claims 1 or 2, wherein the first thermal pad and the second thermal pad are substantially identical or have different dimensions.

4. The PCB according to any of the preceding claims, wherein the PCB further comprises the first IC, the first exposed pad of the first IC is connected to the first thermal pad of the PCB, and the second thermal pad remains unoccupied.

5. The PCB according to claims 1-3, wherein the PCB further comprises the second IC, the second exposed pad of the second IC is connected to the second thermal pad of the PCB, and the first thermal pad remains unoccupied.

6. The PCB according to claims 1-3, wherein both the first and the second thermal pads remain unoccupied or both the first and the second thermal pads are populated with ICs.

7. The PCB according to any of the preceding claims, wherein the first IC and the second IC are video serializer and video deserializer, respectively.

8. A layout structure for the PCB according to any of the preceding claims, comprising:
a first footprint on a first side of the layout structure for a first IC to be populated on the PCB; and
a second footprint on a second side of the layout structure for a second IC to be populated on the PCB;
wherein the first footprint and the second footprint overlap at least partially in a direction perpendicular to the plane of the PCB.

9. The layout structure according to claim 8, wherein geometric centers of the first footprint and the second footprint are aligned and overlap in a direction perpendicular to the plane of the PCB.

10. A method of manufacturing a Printed Circuit Board, PCB, comprising:
providing a substrate;
forming a first thermal pad on the first side of the substrate; and
forming a second thermal pad on the second side of the substrate,
wherein the first thermal pad and the second thermal pad overlap at least partially in a direction perpendicular to the plane of the PCB.

11. The method according to claim 10, further comprising, forming thermal vias in the substrate, with one end of each thermal via connecting to the first thermal pad and the other end connecting to the second thermal pad, or wherein the thermal vias traverse the thermal pads and the substrate.

12. The method according to claims 10 or 11, further comprising: connecting a first exposed pad of a first integrated circuit, IC, to the first thermal pad and remaining the second thermal pad unoccupied.

13. The method according to claims 10 or 11, further comprising: connecting a second exposed pad of a second integrated circuit, IC, to the second thermal pad and remaining the first thermal pad unoccupied.

14. The method according to claims 11-13, wherein the first IC and the second IC are video serializer and video deserializer, respectively.

15. Use of the PCB according to claims 1-7, or the PCB produced according to claims 10-14.
